(19) Europäisches Patentamt
European Patent Office
Office européen des brevets

(11) Veröffentlichungsnummer : **0 076 544**
**B1**

(12) **EUROPÄISCHE PATENTSCHRIFT**

(45) Veröffentlichungstag der Patentschrift : **02.01.86**

(51) Int. Cl.⁴ : **G 02 F 1/09**, G 11 C 13/06, H 01 F 10/06

(21) Anmeldenummer : **82201211.8**

(22) Anmeldetag : **29.09.82**

(54) **Magnetooptischer Modulator.**

(30) Priorität : **03.10.81 DE 3139487**

(43) Veröffentlichungstag der Anmeldung : **13.04.83 Patentblatt 83/15**

(45) Bekanntmachung des Hinweises auf die Patenterteilung : **02.01.86 Patentblatt 86/01**

(84) Benannte Vertragsstaaten : **DE FR GB IT**

(56) Entgegenhaltungen :
**DE-A- 2 606 596**
**DE-A- 2 732 282**
**DE-A- 2 754 876**
**DE-A- 2 815 429**
**APPLIED OPTICS, November 1975, vol. 14, no. 11, B.HILL, J.KRUMME, G. MUCH, R. PEPPERL, J. SCHMIDT, K. SCHMIDT, K. WITTER, H. HEITMANN "Polycube optical memory ia 65x 107 bit read-write and random access optical store", Seiten 2607-2613**

(73) Patentinhaber : **Philips Patentverwaltung GmbH**
**Billstrasse 80**
**D-2000 Hamburg 28 (DE)**
**DE**
**N.V. Philips' Gloeilampenfabrieken**
**Groenewoudseweg 1**
**NL-5621 BA Eindhoven (NL)**
**FR GB IT**

(72) Erfinder : **Heitmann, Heinrich**
**Wacholderweg 30**
**D-2084 Rellingen 1 (DE)**
Erfinder : **Tolksdorf, Wolfgang, Prof.Dr.**
**Königsberger Strasse 34**
**D-2082 Tornesch (DE)**
Erfinder : **Welz, Fritz**
**Hagelsweg 5**
**D-2107 Rosengarten (DE)**
Erfinder : **Witter, Klaus**
**Hinter der Lieth 15**
**D-2000 Hamburg 54 (DE)**

(74) Vertreter : **Nehmzow-David, Fritzi-Maria et al**
**Philips Patentverwaltung GmbH Billstrasse 80 Postfach 10 51 49**
**D-2000 Hamburg 28 (DE)**

**EP 0 076 544 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung bezieht sich auf einen magnetooptischen Modulator mit einer auf einem Substrat angebrachten Schicht aus einem magnetischen Material mit zwei entgegengesetzten, zur Ebene der Schicht senkrechten magnetischen Vorzugsrichtungen, wobei diese Schicht mit einer Anzahl durch Zwischengebiete voneinander getrennter magnetischer Eindomänengebiete versehen ist, in denen unabhängig voneinander die Magnetisierungsrichtung umschaltbar ist, und wobei die Zwischengebiete aus dem durch eine Umsetzung in seinen Eigenschaften veränderten Material der Schicht bestehen.

Die Erfindung bezieht sich weiterhin auf ein Verfahren zur Herstellung eines derartigen magnetooptischen Modulators.

Derartige magnetooptische Modulatoren können in digitalen optischen Speichern, in Bildschirmgeräten und in optischen Druckern verwendet werden. Ein derartiger magnetooptischer Modulator ist aus der DE-A- 27 32 282 bekannt. In der Schicht aus magnetischem Material sind dabei eine Vielzahl magnetischer Domänen bzw. Eindomäneninseln gebildet. Die Magnetisierung in jeder Domäne kann zwei stabile Magnetisierungsrichtungen senkrecht zur Oberfläche der Schicht einnehmen. Die Magnetisierungsrichtung einer Domäne entspricht einem bestimmten Informationsinhalt. So entspricht die eine Magnetisierungsrichtung z. B. einer binären « Null » und die andere Magnetisierungsrichtung einer binären « Eins », oder umgekehrt. Der Informationsinhalt der Domänen kann als eine Hell/Dunkel-Verteilung durch Bestrahlung mit polarisiertem Licht sichtbar gemacht werden, wobei die Domänen den magnetooptischen Faraday-Effekt aufweisen.

Das Einschreiben der Information erfolgt dadurch, daß kurzzeitig ein äußeres Magnetfeld gemäß der gewünschten Magnetisierungsrichtung einer Domäne angelegt und zu gleicher Zeit der Domäne ein Wärmeimpuls zugeführt wird. Bei höheren Temperaturen sind nämlich nur kleinere äußere Magnetfelder für das Umschalten der Magnetisierungsrichtung einer Domäne nötig. Abhängig von der Anwendung des magnetooptischen Modulators wird der Wärmeimpuls auf verschiedene Weisen erzeugt. Bei Anwendung als Speicher wird ein Laserstrahl auf eine Domäne fokussiert. Durch die absorbierte Lichtenergie wird die Domäne erhitzt. Bei Anwendung rein als Lichtmodulator ist jede Domäne mit einem Dünnfilmwiderstand bedeckt, der elektrisch an sich kreuzende Leiterbahnen angeschlossen ist. Der Wärmeimpuls kann auch durch eine Kombination der oben beschriebenen Weisen erzeugt werden.

Da der Informationsinhalt fest zu der Anordnung der magnetischen Gebiete (Domänen oder Eindomänengebiete) gehöhrt, müssen die Lage und die Größe dieser Gebiete genau festgelegt werden. Dies ist auch erforderlich, um ein reproduzierbares Auslesen der Information zu ermöglichen. Zum Erhalten einer großen Informationsdichte soll weiter die Oberfläche der Gebiete möglichst klein sein. Von dem Modulator her gerechnet, sind die minimale Größe und die maximale Dichte der Gebiete durch den kleinsten Durchmesser des Lichtflecks, auf den der Lichtstrahl auf die Schicht fokussiert werden kann, sowie durch die Genauigkeit der Ablenkung begrenzt.

Es ist bekannt, daß in spontan magnetisierten Schichten magnetische Domänen bestehen können, deren Magnetisierungsrichtung der der angrenzenden Domänen entgegengesetzt ist. Benachbarte Domänen werden durch eine magnetische Wand voneinander getrennt. Diese Domänen sind aber bei den Schichten, die für magnetooptische Modulatoren verwendet werden und die mit kleinen Magnetfeldern umschaltbar sein müssen, oft zu groß und lassen sich unter Umständen zu leicht verschieben. Sie müssen also durch zusätzliche Maßnahmen kleiner und ortsstabil gemacht werden. Das Festlegen der magnetischen Eindomänengebiete wird bei der aus der DE-A-27 32 282 bekannten Schicht dadurch erreicht, daß mit Hilfe von Bestrahlung mit hochenergetischen Ionen oder Ionenimplantation und einer eventuellen anschließenden Ätzung von Kernspuren Zwischengebiete erzeugt werden. An den Stellen dieser Zwischengebiete ist ein großer Gradient in den magnetischen Eigenschaften der Schicht vorhanden. Die Zwischengebiete bilden die Wände der Eindomänengebiete. Durch die Bestrahlung mit Ionen lassen sich feine Strukturen erhalten, so daß eine hohe Informationsdichte erzielt werden kann. Außerdem bleibt dabei die glatte Oberfläche der magnetischen Schicht erhalten.

Die Erfindung hat zur Aufgabe, einen magnetooptischen Modulator anzugeben, bei dem durch das Festlegen der magnetischen Domänen die Möglichkeit geschaffen wird, auf einfache Weise auf der magnetischen Schicht angebrachte elektronische Elemente anzuschließen.

Diese Aufgabe wird erfindungsgemäß dadurch gelöst, daß die Zwischengebiete zum Unterschied von den Eindomänengebieten wenigstens teilweise elektrisch leitend sind.

Der Erfindung liegt die Erkenntnis zugrunde, daß es möglich ist, durch Erhitzung des magnetischen Materials in einer reduzierenden Atmosphäre die zwischen den zu bildenden Eindomänengebieten liegenden Gebiete derart umzusetzen, daß damit nicht nur eine hohe Schwelle für die Bewegung der magnetischen Wände erhalten wird, sondern daß diese Zwischengebiete derart umgesetzt werden können, daß eine erhöhte elektrische Leitfähigkeit in diesen Gebieten erhalten wird.

Eine erste Ausführungsform eines magnetooptischen Modulators nach der Erfindung ist dadurch gekennzeichnet, daß auf der Schicht ein erstes und ein zweites System sich kreuzender, gegen die Zwischengebiete elektrisch isolierter Leiterbahnen angebracht sind, wobei diese Leiterbahnen an den Kreuzungspunkten elektrisch gegeneinander isoliert sind, und daß auf jedem Eindomänengebiet eine Widerstandsschicht angebracht ist, die an eine Leiterbahn des ersten Systems und an eine Leiterbahn des zweiten Systems angeschlossen ist.

Falls die Zwischengebiete völlig elektrisch leitend sind, besteht der Vorteil im wesentlichen darin, daß die leitenden Zwischengebiete eine verhältnismäßig hohe Schwelle für die Bewegung magnetischer Wände darstellen. Dies bedeutet, daß die gebildeten Eindomänengebiete in bezug auf ihre Lage stabil sind. Das Gitter von Zwischengebieten läßt nämlich keine Bewegung magnetischer Wände zu. Ein anderer Vorteil ist, daß eine große Absorption für das Ausblenden störenden Lichtes in den Zwischengebieten der magnetischen Speicherschicht erhalten wird.

Eine zweite Ausführungsform eines magnetooptischen Modulators nach der Erfindung ist dadurch gekennzeichnet, daß die elektrisch leitenden Teile der Zwischengebiete ein erstes System elektrischer Leiterbahnen bilden ; daß auf der Oberfläche der Schicht ein zweites System elektrischer Leiterbahnen angebracht ist, wobei die Leiterbahnen des zweiten Systems elektrisch gegen die Leiterbahnen des ersten Systems isoliert sind und die Leiterbahnen des ersten Systems kreuzen, und daß auf jedem Eindomänengebiet eine Widerstandsschicht angebracht ist, die an eine Leiterbahn des ersten Systems und an eine Leiterbahn des zweiten Systems angeschlossen ist.

Dadurch, daß Teile der Zwischengebiete in leitende Gebiete umgesetzt werden, können diese Teile die Funktion von Leiterbahnen übernehmen. Außerdem ist es möglich, dünne Schichten an der Oberfläche wieder in den elektrisch stark isolierenden Zustand umzusetzen. Dadurch wird die Möglichkeit erhalten, ein System von Leiterbahnen auf eine glatte Oberfläche der magnetischen Schicht aufzudampfen und dieses System elektrisch gegen das System von Leiterbahnen in der Schicht zu isolieren.

Eine dritte Ausführungsform ist dadurch gekennzeichnet, daß die elektrisch leitenden Teile der Zwischengebiete ein erstes System von Leiterbahnen und ein zweites System von Leiterbahnen bilden, wobei die Leiterbahnen des zweiten Systems elektrisch gegen die Leiterbahnen des ersten Systems isoliert sind und die Leiterbahnen des ersten Systems kreuzen, und daß auf jedem Eindomänengebiet eine Widerstandsschicht angebracht ist, die an eine Leiterbahn des ersten Systems und an eine Leiterbahn des zweiten Systems angeschlossen ist. Dadurch, daß leitende Gebiete in isolierende Gebiete umgesetzt werden können und umgekehrt, ist es einfach möglich, gegeneinander isolierte Systeme von Leiterbahnen in der Schicht zu bilden.

Eine weitere Ausführungsform ist dadurch gekennzeichnet, daß die Schicht aus magnetischem Material eine ferrimagnetische Granatschicht ist und daß insbesondere die Schicht die Zusammensetzung $(Gd, Bi, Pb)_3 (Fe, Al, Ga, Pt)_5O_{12}$ aufweist.

Eine günstige Ausführungsform ist dadurch gekennzeichnet, daß die Granatschicht die Zusammensetzung

$$Gd_{2,62}Bi_{0,35}Pb_{0,03}Fe_{4,70}Ga_{0,27}Pt_{0,03}O_{12}$$

aufweist.

Ein Verfahren zur Herstellung eines magnetooptischen Modulators nach der Erfindung, bei dem auf einem Substrat eine Schicht aus einem magnetischen Material mit zwei entgegengesetzten, zur Ebene der Schicht senkrechten magnetischen Vorzugsrichtungen angebracht wird, wonach Zwischengebiete der Schicht in ihren Eigenschaften derart umgesetzt werden, daß durch diese Zwischengebiete voneinander getrennte Eindomänengebiete, in denen unabhängig voneinander die Magnetisierungsrichtung umschaltbar ist, gebildet werden, ist dadurch gekennzeichnet, daß die Zwischengebiete einem Reduktionsvorgang unterworfen werden. Durch die Reduktion werden leitende Zwischengebiete erzeugt, die die Eindomänengebiete genau festlegen.

Für die Vorbereitung des Reduktionsschrittes nach der Erfindung kann die Speicherschicht auf verschiedene Weise vorbehandelt werden.

Nach einer ersten Ausführungsform des Verfahrens wird die Schicht vor dem Reduktionsvorgang mit einer Maske, insbesondere in Form einer strukturierten Quarzschicht, abgedeckt, derart, daß die Zwischengebiete unbedeckt sind. Dann wird der Reduktionsvorgang durchgeführt.

Es kann auf diese Weise verfahren werden, wenn die Breite der Zwischengebiete in der Schicht nicht kritisch ist, d. h., wenn nicht sehr genau definierte Zwischengebiete erforderlich sind. Dabei müssen eine derart lange Zeitdauer bzw. eine derart hohe Temperatur des Reduktionsvorgangs gewählt werden, daß die reduzierte Zone die gesamte Dicke der Schicht beansprucht. Dieses Verfahren ist besonders geeignet bei Strukturen, deren Abmessungen groß im Vergleich zur Schichtdicke sind.

Nach einer zweiten günstigen Ausführungsform des Verfahrens wird die ganze Schicht mit mindestens $10^6$ Ionen/$cm^2$ bestrahlt, wobei Ionen mit einer derartigen Masse und Energie verwendet werden, daß die mittlere Eindringtiefe größer als die Schichtdicke ist und ätzbare Kernspuren erhalten werden. Anschließend wird die Schicht mit einer Ätzmaske bedeckt, die derart strukturiert ist, daß die Zwischengebiete unbedeckt sind ; dann werden die Kernspuren geätzt, wonach die maskierte Schicht dem genannten Reduktionsvorgang unterworfen wird.

Nach besonderen Ausführungsformen dieses Verfahrens für die Vorbereitung der Schicht vor dem Reduktionsvorgang wird als Ätzmaske eine strukturierte Quarzschicht verwendet, wobei die Kernspuren chemisch geätzt werden.

Dieser Verfahrensschritt eignet sich besonders gut für dickere magnetische Schichten, z. B. für Schichten mit einer Schichtdicke im Bereich von mehr als 2 μm bis 30 μm. Dieser Verfahrensschritt ist

insbesondere geeignet, wenn Eindomänengebiete gebildet werden müssen, die einen kleinen Flächeninhalt im Verhältnis zu ihrer Höhe besitzen (die Höhe entspricht der Dicke der Schicht). Dabei entstehen sehr genau definierte reduzierte Gebiete, so daß eine sehr genaue Definition der Eindomänengebiete erhalten werden kann.

Die hochenergetischen Ionen lassen beim Eindringen in die magnetische Schicht Kernspuren mit einer hohen Defektdichte und mit einem Durchmesser von etwa 10 nm zurück. Das gestörte Volumen dieser Kernspuren kann durch selektive Ätzmittel entfernt werden, wodurch Kanäle mit einem zylindrischen oder prismatischen Querschnitt entstehen. Die nicht geätzten Kernspuren bleiben magnetisch praktisch unwirksam, weil ihr Durchmesser (etwa 10 nm) erheblich kleiner als die Dicke der magnetischen Wände (etwa 100 nm) ist ; aus diesem Grund kann die Bestrahlung der magnetischen Schicht mit hochenergetischen schweren Ionen ohne Maskierung durchgeführt werden.

Nach einer weiteren günstigen Ausführungsform des Verfahrens wird die Schicht mit einer Maske in Form einer strukturierten Ionen absorbierenden Schicht aus mindestens einem Element mit einem hohen Atomgewicht bedeckt, derart, daß die Zwischengebiete unbedeckt sind. In die Zwischengebiete der Schicht werden Ionen mit einer derartigen Ionendosis implantiert, daß eine genügend hohe Störung des Kristallgitters erhalten wird ; dann wird die absorbierende Schicht entfernt und anschließend wird die Schicht dem Reduktionsvorgang unterworfen.

Nach besonderen Ausführungsformen dieses Verfahrens werden Ionen implantiert, die auf eine derartige Energie beschleunigt sind, daß ihre mittlere Eindringtiefe mindestens 1/5 und höchstens 4/5 der Dicke der Speicherschicht beträgt, die vorteilhafterweise unter 2 µm liegt.

Als absorbierende Schicht wird in diesem Fall eine mit Hilfe eines Photoätzschrittes strukturierte Goldschicht mit einer Schichtdicke angebracht, die größer als die Eindringtiefe der verwendeten Ionen in die absorbierende Schicht ist.

Die Temperatur des Reduktionsvorgangs muß den Wachstumsbedingungen sowie der Zusammensetzung der magnetischen Schicht angepaßt werden. Bei einer passend gewählten Temperatur tritt die Reduktion selektiv in dem mit Ionen implantierten Gebiet auf. Das nichtimplantierte Gebiet ändert sich nur in geringem Maße.

Dieses Verfahren kann mit Vorteil bei Schichtdicken bis etwa 2 µm verwendet werden und ergibt sehr genau definierte Eindomänengebiete.

Der Reduktionsvorgang wird vorzugsweise in einer $N_2/H_2$-Atmosphäre mit 90 % $N_2$ + 10 % $H_2$ bei Temperaturen im Bereich von 350 bis 600 °C während 0,5 bis 24 Stunden durchgeführt.

Weiter ist es vorteilhaft, daß die reduzierten Gebiete der Schicht durch Tempern während etwa 24 Stunden in Sauerstoff bei einer Temperatur von etwa 900 °C im wesentlichen wieder in den ursprünglichen Zustand umgewandelt werden können. Durch die Wahl einer geeigneten Temperatur und Zeitdauer können außerdem dünne Schichten an der Oberfläche teilweise wieder in den elektrisch stark isolierenden Stand umgewandelt werden. Dadurch werden jeweils einfache Möglichkeiten zur Bildung eines Systems gegeneinander isolierter Leiterbahnen in der Schicht und zur Isolierung eines in der Schicht gebildeten Systems von Leiterbahnen in bezug auf ein aufgedampftes System von Leiterbahnen erhalten.

Einige Ausführungsformen der Erfindung sind in der Zeichnung dargestellt und werden im folgenden näher beschrieben. Es zeigen :

Figur 1a eine Draufsicht auf eine erste Ausführungsform eines magnetooptischen Modulators,
Figur 1b einen Schnitt längs der Linie Ib-Ib der Fig. 1a,
Figur 2a eine Draufsicht auf eine zweite Ausführungsform eines magnetooptischen Modulators,
Figur 2b einen Schnitt längs der Linie IIb-IIb der Fig. 2a,
Figur 3a eine Draufsicht auf eine dritte Ausführungsform eines magnetooptischen Modulators, und
Figur 3b einen Schnitt längs der Linie IIIb-IIIb der Fig. 3a.

In Fig. 1a ist eine Draufsicht auf und in Fig. 1b ein Schnitt längs der Linie Ib-Ib der Fig. 1a durch eine erste Ausführungsform eines magnetooptischen Modulators dargestellt. Der Modulator wird durch ein Substrat 1 gebildet, auf dem eine ferrimagnetische Granatschicht 2 angebracht ist. In dieser Granatschicht 2 sind eine Vielzahl durch leitende Zwischengebiete 4 voneinander getrennter Eindomänengebiete 3 gebildet. Die leitenden Zwischengebiete sind mit einer Isolierschicht 8 überzogen. Auf der Schicht 8 sind ein erstes System von Leiterbahnen 5 und ein zweites System Leiterbahnen 6 angebracht. Die Leiterbahnen 5 und 6 sind an den Kreuzungspunkten gegeneinander isoliert. Über jedem Eindomänengebiet 3 ist eine Dünnfilmwiderstandsschicht 7 angebracht, die an eine Leiterbahn 5 bzw. eine Leiterbahn 6 angeschlossen ist. Durch das Anlegen von Spannungsimpulsen an eine Leiterbahn 5 und eine Leiterbahn 6 wird die Widerstandsschicht 7 am Kreuzungspunkt und damit das zugehörige Domänengebiet 3 erhitzt. Durch gleichzeitiges Anlegen eines äußeren Magnetfeldes kann die Magnetisierungsrichtung des betreffenden Domänengebietes umgekehrt werden.

Die Erzeugung der leitenden Zwischengebiete 4 in der Schicht 2 wird anhand des folgenden praktischen Verfahrens näher erläutert.

### Beispiel 1

Bei geringen Maßhaltigkeitsanforderungen in bezug auf die Breite der Zwischengebiete 4 der

magnetischen Schicht 2 kann die Reduktion der Zwischengebiete 4, ohne daß vorher eine hohe Defektdichte im Kristallgitter, z. B. durch Bestrahlung mit hochenergetischen Ionen oder durch Ionenimplantation bewirkt wird, direkt durchgeführt werden. Bei einem Ausführungsbeispiel wurde dazu auf folgende Weise verfahren :

Eine 3 µm dicke epitaktisch auf einer einkristallinen Substratscheibe 1 angewachsene ferrimagnetische Granatschicht 2 für magnetooptische Anwendungen mit der Zusammensetzung

$$Gd_{2,62}Bi_{0,35}Pb_{0,03}Fe_{4,70}Ga_{0,27}Pt_{0,03}O_{12}$$

wurde durch eine chemische Transportreaktion mit einer 100 nm dicken $SiO_2$-Schicht überzogen. In diese Quarzschicht wurde anschließend über eine Photolackmaske mit einer gepufferten HF-Lösung eine Struktur geätzt, die aus quadratischen Quarzinseln von 17 µm × 17 µm und dazwischenliegenden Gebieten mit einer Breite von 3 µm bestand. Die so behandelte Granatschicht 2 wurde dann eine Stunde lang bei 500 °C in einen Ofen gebracht, in dem eine Atmosphäre aus 90 % $N_2$ + 10 % $H_2$ herrschte.

Nach dieser reduzierenden Behandlung entstanden in der Granatschicht 2 an den nicht mit der Quarzmaske bedeckten Stellen stark absorbierende elektrisch leitende Zwischengebiete 4 mit einem Flächenwiderstand $R_F$ = 100 Ω. Die Zwischengebiete erstreckten sich infolge von Diffusion über etwa 1,5 µm unter der Quarzabdeckung, so daß transparente quadratische Eindomänengebiete 3 mit Abmessungen von jeweils 14 µm × 14 µm übrigblieben.

## Beispiel 2

Bei Schichtdicken bis etwa 30 µm kann eine sehr gute genaue Maßhaltigkeit der Eindomänengebiete 3 erhalten werden, wenn die Schicht 2 vor der reduzierenden Behandlung mit mindestens $10^6$ Ionen/$cm^2$ bestrahlt wird. Bei einem Ausführungsbeispiel wurde eine 3 µm dicke Schicht 2 aus ferrimagnetischem Granatmaterial mit etwa $10^9$ Xenonionen/$cm^2$ mit einer spezifischen Energie von 6 meV/Nukleon bestrahlt. Dann wurde die so bestrahlte Schicht 2 mit einer Quarzschicht, die zur Bildung einer Maske diente, durch chemische Transportreaktion bedeckt. Für die Anbringung der Quarzschicht kann auch jedes andere dem Fachmann geläufige Verfahren, z. B. eine plasmaaktivierte chemische Transportreaktion, angewendet werden. Die $SiO_2$-Schicht wurde anschließend mit der gewünschten Maskenstruktur versehen, derart, daß die in der Schicht 2 zu erzeugenden Eindomänengebiete 3 durch die Maske abgedeckt sind und die bestrahlten Gebiete der Granatschicht 2 zwischen diesen zu erzeugenden Eindomänengebieten 3 freiliegen. Die Strukturierung der Quarzschicht kann mit Hilfe eines Photoätzschrittes stattfinden.

Die so maskierte Schicht 2 wurde dann einem Ätzvorgang zur Ätzung der Kernspuren unterworfen. Es wurden selektive Ätzlösungen, z. B. 70 Vol.% $H_2O$ + 30 Vol.% $H_3PO_4$, Temperatur von 60 °C, gefunden, in denen der durch die Bestrahlung gestörte Kristall ein viel größeres Lösungsvermögen als der ungestörte Kristall aufweist. Beim Ätzen mit der oben beschriebenen $H_2O/H_3PO_4$-Ätzlösung werden innerhalb von etwa 10 min Kanäle an den Kernspuren von etwa 18 nm Durchmesser in der Schicht 2 gebildet.

Diese Schicht 2 mit vergrößerten Kernspuren in den Zwischengebieten 4 wurde dann maskiert einem Reduktionsvorgang in einer $N_2/H_2$-Atmosphäre mit 90 % $N_2$ + 10 % $H_2$ bei einer Temperatur von 450 °C während 1 Stunde unterworfen.

Auf diese Weise wurden sehr genau definierte Zwischengebiete 4 in der Schicht 2 erzeugt, die einen Flächenwiderstand $R_F$ von etwa 100 Ω aufwiesen und also elektrisch leitend geworden waren. Die reduzierten Zwischengebiete 4 der Schicht 2 wiesen eine starke optische Absorption auf. Dieses durch Erhitzung in einer reduzierenden Atmosphäre erzeugte Gittermuster läßt keine Bewegung magnetischer Wände durch das Gitter zu.

## Beispiel 3

Bei Schichtdicken bis etwa 2 µm können sehr genau definierte optisch stark absorbierende Zwischengebiete 4 in der magnetischen Schicht 2 dadurch erzeugt werden, daß Defekte an diesen Stellen in der Schicht 2 durch Ionenimplantation und anschließendes selektives Reduzieren gebildet werden.

Nach einem Ausführungsbeispiel wurde eine 2 µm dicke ferrimagnetische Granatschicht 2 mit der Zusammensetzung

$$Gd_{2,62}Bi_{0,35}Pb_{0,03}Fe_{4,70}Ga_{0,27}Pt_{0,03}O_{12}$$

zunächst mit einer Maske in Form einer 0,5 µm dicken absorbierenden Goldschicht bedeckt, die in einem anschließenden Photoätzschritt derart strukturiert wurde, daß die in der Schicht 2 zu erzeugenden Eindomänengebiete 3 nach wie vor mit der Maskierungsschicht bedeckt waren, aber die Zwischengebiete 4 unmaskiert waren. In die Goldschicht wurde eine Kanalstruktur geätzt ; die Kanäle erstreckten sich dabei bis auf die magnetische Schicht 2 und waren etwa 2 bis 3 µm breit (bedingt durch das beschränkte Auflösungsvermögen bei üblicherweise angewandten positiven Photolacken). Anschließend wurden

Borionen mit einer Ionendosis $> 10^{15}/cm^2$ und einer Energie von 350 keV implantiert. Das Material der Schicht 2 wird dabei nur an den Stellen der Kanalstrukturen der maskierenden Goldschicht gestört. Die Borionen weisen bei einer Energie von 350 keV eine Eindringtiefe von 0,8 $\mu m$ in das oben beschriebene Granatmaterial auf. Dann wurde die maskierende Goldschicht entfernt, und die Schicht 2 wurde einem Reduktionsvorgang in einer $N_2/H_2$-Atmosphäre mit 90 % $N_2$ + 10 % $H_2$ bei einer Temperatur von 600 °C während 1 Stunde unterworfen. Bei diesem Reduktionsvorgang tritt die Reduktion selektiv in dem mit Bor implantierten Gebiet der magnetischen Schicht auf. Das nichtimplantierte Gebiet ändert sich nur in geringem Maß. Nach der Reduktion waren genau definierte optisch stark absorbierende elektrisch leitende Zwischengebiete 4 in der Schicht 2 zwischen den gewünschten Eindomänengebieten 3 entstanden, die eine gute örtliche Fixierung aufwiesen.

Eine zweite Ausführungsform eines magnetooptischen Modulators wird anhand der Fig. 2a, die eine Draufsicht zeigt, näher erläutert. Fig. 2b zeigt einen Schnitt längs der Linie IIb-IIb in Fig. 2a. Entsprechende Teile sind mit denselben Bezugsziffern wie in Fig. 1 bezeichnet. Die Domänengebiete 3 werden auf gleiche Weise erzeugt wie anhand des Beispiels 2 oder des Beispiels 3 beschrieben wurde, jedoch mit dem Unterschied, daß beim Reduktionsschritt eine derartige Maskierung angewendet wird, daß nur die gestrichelten Gebiete 10 reduziert werden.

Die reduzierten leitenden Gebiete 10 bilden ein erstes System von Leiterbahnen 10. Ein zweites System von Leiterbahnen 6 wird wieder auf die Schicht 2 aufgedampft. An den Kreuzungspunkten sind die Leiterbahnen 6 und 10 gegeneinander durch einen Isolator 8 isoliert. Statt durch einen Isolator 8 können die Leiterbahnen 6 und 10 auch dadurch gegeneinander isoliert werden, daß an jedem Kreuzungspunkt eine dünne Schicht an der Oberfläche einer Leiterbahn 10 wieder in den ursprünglichen isolierenden Zustand umgewandelt wird. Dies kann durch Tempern in Sauerstoff bei einer passenden Wahl der Temperatur und Zeitdauer erfolgen. Auf jedem Domänengebiet 3 ist wieder ein Dünnfilmwiderstand 7 angebracht, der an eine Leiterbahn 6 und eine Leiterbahn 10 angeschlossen ist.

Eine dritte Ausführungsform eines magnetooptischen Modulators wird anhand der Fig. 3a näher erläutert, die eine Draufsicht zeigt, während Fig. 3b einen Schnitt längs der Linie IIIb-IIIb in Fig. 3a darstellt.

Entsprechende Teile sind mit denselben Bezugsziffern wie in Fig. 2 bezeichnet. Bei dieser Ausführungsform werden zunächst wieder Leiterbahnen 10 gebildet. Dann werden durch Tempern in Sauerstoff die Gebiete 15 in den Leiterbahnen 10 wieder in den isolierenden Zustand umgewandelt. Anschließend werden Leiterbahnen 20 gebildet, die sich nur über einen Teil der Dicke der Schicht 2 erstrecken. Auf diese Weise werden in der Schicht 2 Leiterbahnen 10 und 20 gebildet, die an den Kreuzungspunkten gegeneinander isoliert sind.

**Patentansprüche**

1. Magnetooptischer Modulator mit einer auf einem Substrat angebrachten Schicht aus einem magnetischen Material mit zwei entgegengesetzten, zur Ebene der Schicht senkrechten magnetischen Vorzugsrichtungen, wobei diese Schicht mit einer Anzahl durch Zwischengebiete voneinander getrennter magnetischer Eindomänengebiete versehen ist, in denen unabhängig voneinander die Magnetisierungsrichtung umschaltbar ist, und wobei die Zwischengebiete aus dem durch eine Umsetzung in seinen Eigenschaften veränderten Material der Schicht bestehen, dadurch gekennzeichnet, daß die Zwischengebiete zum Unterschied von den Eindomänengebieten wenigstens teilweise elektrisch leitend sind.

2. Magnetooptischer Modulator nach Anspruch 1, dadurch gekennzeichnet, daß auf der Schicht ein erstes und ein zweites System sich kreuzender, gegen die Zwischengebiete elektrisch isolierter Leiterbahnen angebracht sind, wobei diese Leiterbahnen an den Kreuzungspunkten elektrisch gegeneinander isoliert sind, und daß auf jedem Eindomänengebiet eine Widerstandsschicht angebracht ist, die an eine Leiterbahn des ersten Systems und an eine Leiterbahn des zweiten Systems angeschlossen ist.

3. Magnetooptischer Modulator nach Anspruch 1, dadurch gekennzeichnet, daß die elektrisch leitenden Teile der Zwischengebiete ein erstes System elektrischer Leiterbahnen bilden, daß auf der Oberfläche der Schicht ein zweites System elektrischer Leiterbahnen angebracht ist, wobei die Leiterbahnen des zweiten Systems elektrisch gegen die Leiterbahnen des ersten Systems isoliert sind und die Leiterbahnen des ersten Systems kreuzen, und daß auf jedem Eindomänengebiet eine Widerstandsschicht angebracht ist, die an eine Leiterbahn des ersten Systems und an eine Leiterbahn des zweiten Systems angeschlossen ist.

4. Magnetooptischer Modulator nach Anspruch 1, dadurch gekennzeichnet, daß die elektrisch leitenden Teile der Zwischengebiete ein erstes System von Leiterbahnen und ein zweites System von Leiterbahnen bilden, wobei die Leiterbahnen des zweiten Systems elektrisch gegen die Leiterbahnen des ersten Systems isoliert sind und die Leiterbahnen des ersten Systems kreuzen, und daß auf jedem Eindomänengebiet eine Widerstandsschicht angebracht ist, die an eine Leiterbahn des ersten Systems und an eine Leiterbahn des zweiten Systems angeschlossen ist.

5. Magnetooptischer Modulator nach einem der Ansprüche 1 bis 4, dadurch gekennzeichnet, daß die Schicht aus magnetischem Material eine ferrimagnetische Granatschicht ist.

6. Magnetooptischer Modulator nach Anspruch 5, dadurch gekennzeichnet, daß die Granatschicht die allgemeine Zusammensetzung

$$(Gd, Bi, Pb)_3 (Fe, Al, Ga, Pt)_5O_{12}$$

aufweist.

7. Magnetooptischer Modulator nach Anspruch 6, dadurch gekennzeichnet, daß die Granatschicht die Zusammensetzung

$$Gd_{2.62}Bi_{0.35}Pb_{0.03}Fe_{4.70}Ga_{0.27}Pt_{0.03}O_{12}$$

aufweist.

8. Verfahren zur Herstellung eines magnetooptischen Modulators, bei dem auf einem Substrat eine Schicht aus einem magnetischen Material mit zwei entgegengesetzten zur Ebene der Schicht senkrechten magnetischen Vorzugsrichtungen angebracht wird, wonach Zwischengebiete der Schicht in ihren Eigenschaften derart umgesetzt werden, daß durch diese Zwischengebiete voneinander getrennte Eindomänengebiete, in denen unabhängig voneinander die Magnetisierungsrichtung umschaltbar ist, gebildet werden, dadurch gekennzeichnet, daß die Zwischengebiete einem Reduktionsvorgang unterworfen werden.

9. Verfahren nach Anspruch 8, dadurch gekennzeichnet, daß die Schicht vor dem Reduktionsvorgang mit einer Maske abgedeckt wird, derart, daß die Zwischengebiete unbedeckt sind.

10. Verfahren nach Anspruch 9, dadurch gekennzeichnet, daß als Maske eine strukturierte Quarzschicht verwendet wird.

11. Verfahren nach Anspruch 8, dadurch gekennzeichnet, daß die gesamte Schicht mit mindestens $10^6$ Ionen/$cm^2$ bestrahlt wird, wobei Ionen mit einer derartigen Masse und Energie verwendet werden, daß die mittlere Eindringtiefe größer als die Schichtdicke ist und ätzbare Kernspuren entstehen ; daß die Schicht dann mit einer Ätzmaske bedeckt wird, die derart strukturiert ist, daß die Zwischengebiete unbedeckt sind ; daß danach die Kernspuren geätzt werden, und daß die maskierte Schicht, anschließend dem Reduktionsvorgang unterworfen wird.

12. Verfahren nach Anspruch 11, dadurch gekennzeichnet, daß als Ätzmaske eine strukturierte Quarzschicht verwendet wird.

13. Verfahren nach den Ansprüchen 11 oder 12, dadurch gekennzeichnet, daß eine Schicht mit einer Schichtdicke im Bereich von mehr als 2 µm bis 30 µm verwendet wird.

14. Verfahren nach Anspruch 8, dadurch gekennzeichnet, daß die Schicht mit einer Maske in Form einer strukturierten, Ionen absorbierenden Schicht aus mindestens einem Element mit einem hohen Atomgewicht derart abgedeckt wird, daß die Zwischengebiete unbedeckt sind, daß in die Zwischengebiete der Schicht Ionen mit einer derartigen Ionendosis implantiert werden, daß eine genügend große Störung des Kristalls erreicht wird, daß die absorbierende Schicht entfernt wird, und daß dann die Schicht dem Reduktionsvorgang unterworfen wird.

15. Verfahren nach Anspruch 14, dadurch gekennzeichnet, daß Ionen implantiert werden, die auf eine derartige Energie beschleunigt sind, daß ihre mittlere Eindringtiefe mindestens 1/5 und höchstens 4/5 der Schichtdicke beträgt.

16. Verfahren nach Anspruch 14 oder 15, dadurch gekennzeichnet, daß Borionen implantiert werden.

17. Verfahren nach Anspruch 14, 15 oder 16, dadurch gekennzeichnet, daß eine Schicht mit einer Schichtdicke unter 2 µm verwendet wird.

18. Verfahren nach einem der Ansprüche 14 bis 17, dadurch gekennzeichnet, daß als absorbierende Schicht eine mit Hilfe eines Photoätzschrittes strukturierte Goldschicht angebracht wird.

19. Verfahren nach Anspruch 18, dadurch gekennzeichnet, daß die Goldschicht mit einer Schichtdicke angebracht wird, die größer als die Eindringtiefe der verwendeten Ionen in die absorbierende Schicht ist.

20. Verfahren nach einem der Ansprüche 8 bis 19, dadurch gekennzeichnet, daß der Reduktionsvorgang in einer Atmosphäre von 90 % $N_2$ + 10 % $H_2$ bei Temperaturen im Bereich von 350 bis 600 °C während 0,5 bis 24 Stunden durchgeführt wird.

21. Verfahren nach einem der Ansprüche 8 bis 20, dadurch gekennzeichnet, daß ein Teil der reduzierten Gebiete einem Tempervorgang unterworfen wird.

22. Verfahren nach Anspruch 21, dadurch gekennzeichnet, daß das Tempern bei einer Temperatur von etwa 900 °C während etwa 24 Stunden durchgeführt wird.

**Claims**

1. A magneto-optical modulator having a layer of a magnetic material which is provided on a substrate and has two opposite easy axes of magnetization perpendicular to the plane of the layer, said

layer comprising a number of magnetic single domain areas separated from each other by intermediate areas in which the direction of magnetization can be switched independently of each other, and in which the intermediate areas consist of the material of the layer changed in its properties by a conversion, characterized in that the intermediate areas for distinction from the single domain areas are at least partly electrically conductive.

2. A magneto-optical modulator as claimed in Claim 1, characterized in that a first and a second system of crossing conductor paths insulated electrically with respect to the intermediate areas are provided on the layer, said conductor paths being insulated electrically from each other at the crossings, and that a resistive layer is provided on each domain area and is connected to a conductor path of the first system and to a conductor path of the second system.

3. A magneto-optical modulator as claimed in Claim 1, characterized in that the electrically conductive parts of the intermediate areas form a first system of electrical conductor paths ; that on the surface of the layer a second system of electrical conductor paths is provided, the conductor paths of the second system being insulated electrically from the conductor paths of the first system and crossing the conductor paths of the first system, and that on each domain area a resistive layer is provided which is connected to a conductor path of the first system and to a conductor path of the second system.

4. A magneto-optical modulator as claimed in Claim 1, characterized in that the electrically conductive parts of the intermediate areas form a first system of conductor paths and a second system of conductor paths, the conductor paths of the second system being insulated electrically from the conductor path of the first system and crossing the conductor paths of the first system, and that on each domain area a resistive layer is provided which is connected to a conductor path of the first system and to a conductor path of the second system.

5. A magneto-optical modulator as claimed in Claim 1 to 4, characterized in that the layer of magnetic material is a ferrimagnetic garnet layer.

6. A magneto-optical modulator as claimed in Claim 5, characterized in that the garnet layer has the general composition $(Gd, Bi, Pb)_3 (Fe, Al, Ga, Pt)_5O_{12}$.

7. A magneto-optical modulator as claimed in Claim 6, characterized in that the garnet layer has the composition

$$Gd_{2.62}Bi_{0.35}Pb_{0.03}Fe_{4.70}Ga_{0.27}Pt_{0.03}O_{12}.$$

8. A method of manufacturing a magneto-optical modulator in which a layer of a magnetic material having two opposite easy axes of magnetization perpendicular to the plane of the layer is provided on a substrate, after which intermediate areas of the layer are converted in their properties in such a manner that single domain areas separated from each other by said intermediate areas are formed in which the direction of magnetization can be switched independently of each other, characterized in that the intermediate areas are subjected to a reduction process.

9. A method as claimed in Claim 8, characterized in that the layer is covered by a mask prior to the reduction process in such a manner that the intermediate areas are not covered.

10. A method as claimed in Claim 9, characterized in that a structured quartz layer is used as a mask.

11. A method as claimed in Claim 8, characterized in that the whole layer is exposed to at least $10^6$ ions/$cm^2$, ions having such a mass and energy being used that the average depth of penetration is larger than the layer thickness and that etchable core tracks are formed ; that the layer is then covered with an etching mask which is structured so that the intermediate areas are not covered ; that the core tracks are then etched and that the masked layer is subsequently subjected to the reduction process.

12. A method as claimed in Claim 11, characterized in that a structured quartz layer is used as an etching mask.

13. A method as claimed in Claims 11 or 12, characterized in that a layer having a layer thickness in the range from more than 2 μm to 30 μm is used.

14. A method as claimed in Claim 8, characterized in that the layer is covered with a mask in the form of a structured ions-absorbing layer of at least an element having a high atomic weight in such a manner that the intermediate areas are not covered ; that in the intermediate areas of the layer ions are implanted with such an ion dose that a sufficiently large disturbance of the crystal is achieved, that the absorbing layer is removed and that the layer is then subjected to the reduction process.

15. A method as claimed in Claim 14, characterized in that ions are implanted which are accelerated to such an energy that their average depth of penetration is at least 1/5 and at most 4/5 of the layer thickness.

16. A method as claimed in Claim 14 or 15, characterized in that boron ions are implanted.

17. A method as claimed in Claim 14, 15 or 16, characterized in that a layer having a layer thickness below 2 μm is used.

18. A method as claimed in any of Claims 14 to 17, characterized in that a gold layer structured by means of a photo-etching step is provided as an absorbing layer.

19. A method as claimed in Claim 18, characterized in that the gold layer is provided in a layer thickness which is larger than the depth of penetration into the absorbing layer of the ions used.

20. A method as claimed in any of the Claims 8 to 19, characterized in that the reduction process is

carried out in an atmosphere of 90 % $N_2$ + 10 % $H_2$ at temperatures in the range from 350 to 600 °C for 0.5 to 24 hours.

21. A method as claimed in any of the Claims 8 to 20, characterized in that a part of the reduced areas is subjected to a tempering process.

22. A method as claimed in Claim 21, characterized in that tempering is carried out at a temperature of approximately 900 °C for approximately 24 hours.

**Revendications**

1. Modulateur magnéto-optique sur un substrat duquel est appliquée une couche en un matériau magnétique, présentant deux directions préférentielles magnétiques opposées perpendiculaires au plan de la couche, cette couche étant munie de plusieurs régions monodomaines magnétiques espacées, dans lesquelles la direction de magnétisation peut être inversée de façon indépendante les unes des autres, les régions intermédiaires étant constituées par le matériau de la couche, dont les propriétés sont modifiées par une conversion, caractérisé en ce que par opposition aux régions monodomaines, les régions intermédiaires sont au moins partiellement électroconductrices.

2. Modulateur magnéto-optique selon la revendication 1, caractérisé en ce que sur la couche sont appliqués un premier et un deuxième système de pistes conductrices qui se croisent et qui sont isolées électriquement par rapport aux régions intermédiaires, ces pistes conductrices étant isolées les unes des autres aux points de croisement, et qu'une couche de résistance est appliquée sur chaque région monodomaine et est connectée à une piste conductrice du premier système et à une piste conductrice du deuxième système.

3. Modulateur magnéto-optique selon la revendication 1, caractérisé en ce que les parties électro-conductrices des régions intermédiaires constituent un premier système de pistes électro-conductrices, qu'un deuxième système de pistes conductrices est appliqué sur la surface de la couche, les pistes conductrices du deuxième système étant isolées électriquement par rapport aux pistes conductrices du premier système et croisent les pistes conductrices du premier système et qu'une couche de résistance est appliquée sur chaque région monodomaine et connectée à une piste conductrice du premier système et à une piste conductrice du deuxième système.

4. Modulateur magnéto-optique selon la revendication 1, caractérisé en ce que les parties électro-conductrices des régions intermédiaires constituent un premier système de pistes conductrices et un deuxième système de pistes conductrices, les pistes conductrices du deuxième système étant isolées électriquement par rapport aux pistes conductrices du premier système et croisent les pistes conductrices du premier système, et qu'une couche de résistance est appliquée sur chaque région monodomaine et connectée à une piste conductrice du premier système et à une piste conductrice du deuxième système.

5. Modulateur magnéto-optique selon l'une des revendications 1 à 4, caractérisé en ce que la couche en matériau magnétique est une couche de grenat ferrimagnétique.

6. Modulateur magnéto-optique selon la revendication 5, caractérisé en ce que la couche de grenat presente la composition générale $(Gd, Bi, Pb)_3 (Fe, Al, Ga, Pt)_5O_{12}$.

7. Modulateur magnéto-optique selon la revendication 6, caractérisé en ce que la couche de grenat présente la composition

$$Gd_{2,62}Bi_{0,35}Pb_{0,03}Fe_{4,70}Ga_{0,27}Pt_{0,03}O_{12}.$$

8. Procédé pour la réalisation d'un modulateur magnéto-optique, selon lequel une couche en un matériau magnétique présentant deux directions préférentielles magnétiques opposées perpendiculaires au plan de la couche est appliquée sur un substrat, après quoi les propriétés des régions intermédiaires de la couche sont converties de façon à former des régions monodomaines séparées par ces régions intermédiaires dans lesquelles la direction de magnétisation peut être inversée d'une façon indépendante, caractérisé en ce que les régions intermédiaires sont soumises à un processus de réduction.

9. Procédé selon la revendication 8, caractérisé en ce qu'avant le processus de réduction, la couche est recouverte d'un masque de façon à découvrir la région intermédiaire.

10. Procédé selon la revendication 9, caractérisé en ce que comme masque est utilisée une couche de quartz structurée.

11. Procédé selon la revendication 8, caractérisé en ce que toute la couche est irradiée avec au moins $10^6$ ions/$cm^2$, les ions présentant une masse et une énergie telles que la profondeur de pénétration moyenne est supérieure à l'épaisseur de couche et qu'il se forme des traces nucléaires ; que la couche est ensuite recouverte d'un masque de décapage qui est structuré de façon que la région intermédiaire soit découverte ; qu'ensuite les traces nucléaires sont décapées et que la couche masquée est ensuite soumise à un processus de réduction.

12. Procédé selon la revendication 11, caractérisé en ce que comme masque de décapage est utilisée une couche de quartz structurée.

13. Procédé selon la revendication 11 ou 12, caractérisé par l'utilisation d'une couche d'une épaisseur supérieure à 2 à 30 μm.

14. Procédé selon la revendication 8, caractérisé en ce que la couche est recouverte d'un masque sous forme d'une couche absorbant des ions structurée constituée par au moins un élément présentant un poids atomique élevé de façon à découvrir la région intermédiaire, que dans les régions intermédiaires de la couche sont implantés des ions d'une dose ionique telle qu'il en résulte une perturbation suffisamment grande du cristal, que la couche absorbante est éloignée et ensuite, que la couche est soumise à un processus de réduction.

15. Procédé selon la revendication 14, caractérisé en ce que des ions sont implantés, qui sont accélérés à une énergie telle que leur profondeur de pénétration moyenne est d'au moins 1/5 et d'au maximum 4/5 de l'épaisseur de couche.

16. Procédé selon la revendication 14 ou 15, caractérisé par l'implantation d'ions bore.

17. Procédé selon la revendication 14, 15 ou 16 caractérisé par l'utilisation d'une couche d'une épaisseur inférieure à 2 μm.

18. Procédé selon l'une des revendications 14 à 17, caractérisé en ce que comme couche absorbante est appliquée une couche d'or structurée à l'aide d'un processus de photodécapage.

19. Procédé selon la revendication 18, caractérisé en ce que la couche d'or est appliquée dans une épaisseur qui est supérieure à la profondeur de pénétration des ions utilisés dans la couche absorbante.

20. Procédé selon l'une des revendications 8 à 19, caractérisé en ce que le processus de réduction est effectué dans une atmosphère de 90 % de $N_2$ + 10 % de $H_2$ à la température située dans la gamme de 350 à 600 °C pendant 0,5 à 24 heure(s).

21. Procédé selon l'une des revendications 8 à 20, caractérisé en ce qu'une partie de la région réduite est soumise à un processus de recuit.

22. Procédé selon la revendication 21, caractérisé en ce que le recuit s'effectue à une température d'environ 900 °C pendant environ 24 heures.

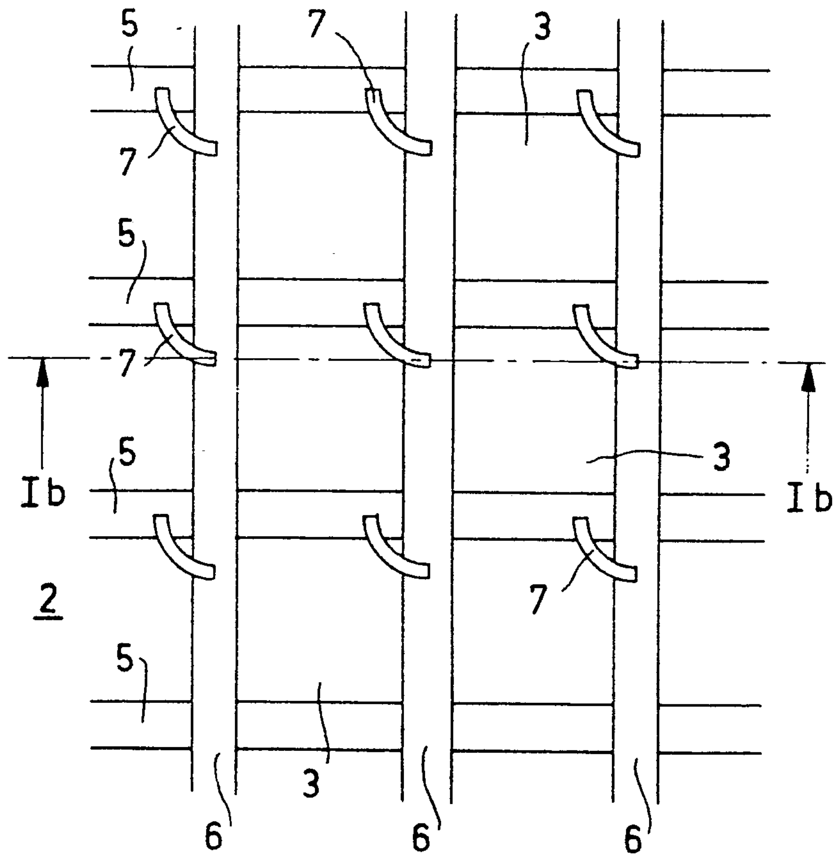


FIG.1a

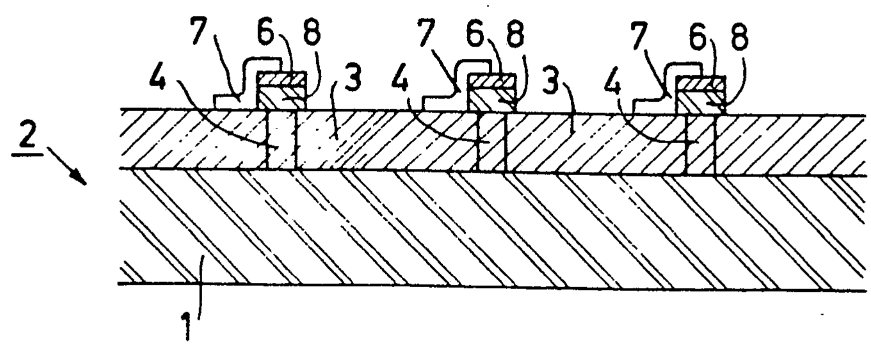


FIG.1b

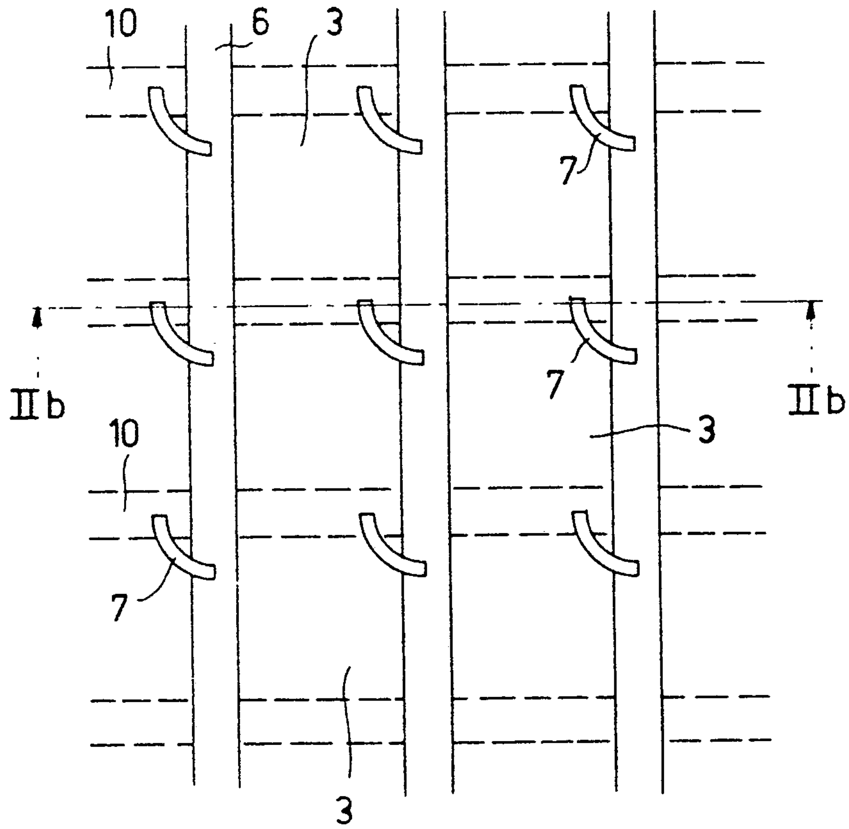


FIG.2a

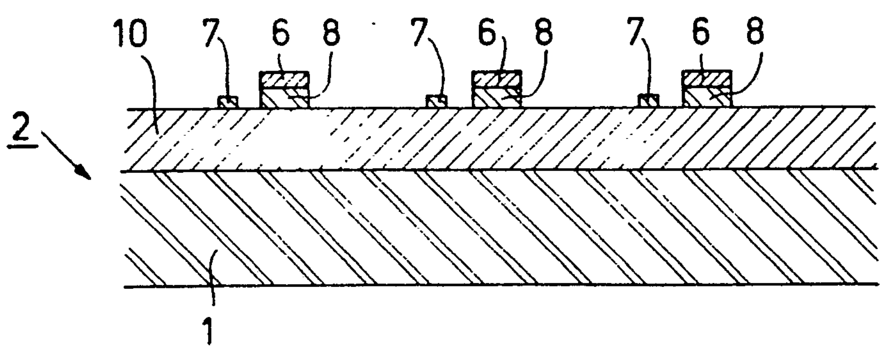


FIG.2b

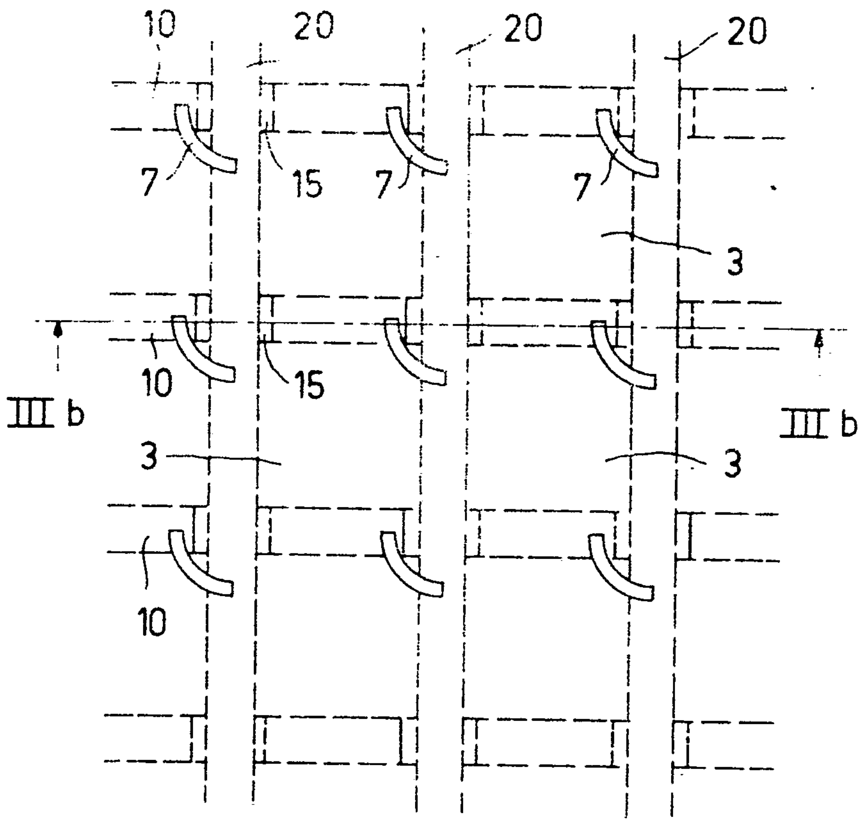


FIG.3a

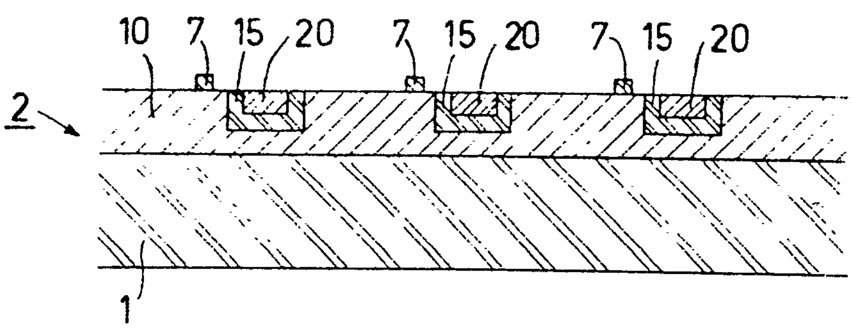


FIG.3b